# EUROPEAN PATENT SPECIFICATION

(11) **EP 2 805 336 B1**
(45) Date of publication and mention of the grant of the patent: **23.05.2018**
(21) Application number: 13738046.5
(22) Date of filing: 17.01.2013
(51) Int. Cl.: H01B 13/00, H01B 12/06

(54) **SUPERCONDUCTING WIRE AND METHOD OF FORMING THE SAME**
SUPRALEITENDER DRAHT UND VERFAHREN ZU SEINER HERSTELLUNG
CÂBLE SUPRACONDUCTEUR ET PROCÉDÉ DE FORMATION

(30) Priority: 17.01.2012 KR 20120005358
(43) Date of publication of application: 26.11.2014
(73) Proprietor: Sunam Co., Ltd., Wongok-myeon Anseong-si, Gyeonggi-do 456-812 (KR)
(72) Inventor: MOON, Seung Hyun, Seongnam-si Gyeonggi-do 463-809 (KR); LEE, Jae Hun, Gimpo-si Gyeonggi-do 415-737 (KR); LEE, Hun-Ju, Yongin-si Gyeonggi-do 448-120 (KR)
(74) Representative: Mounteney, Simon James
(86) International application number: PCT/KR2013/000369
(87) International publication number: WO 2013/109065

(56) References cited:
- JP-A- 2011 113 665
- KR-A- 20010 038 805
- KR-A- 20060 019 444
- US-A- 5 340 794
- US-A- 5 665 682
- US-A1- 2009 247 413
- US-A1- 2010 048 406
- BACKEN E ET AL: "Improved Pinning in YBCO Based Quasi-Multilayers Prepared by On and Off-Axis Pulsed Laser Deposition", IEEE TRANSACTIONS ON APPLIED SUPERCONDUCTIVITY, IEEE SERVICE CENTER, LOS ALAMITOS, CA, US, vol. 17, no. 2, 1 June 2007 (2007-06-01), pages 3733-3736, XP011188790, ISSN: 1051-8223, DOI: 10.1109/TASC.2007.897937

## Description

### Technical Field

The present disclosure herein relates to a superconducting wire.

### Background Art

A superconductor loses all its resistance below critical temperature and a large amount of an electric current may pass through the superconductor without loss. Recently, a second generation high temperature superconducting wire (Coated Conductor) including a superconducting film on a metal substrate or on a thin buffer layer including a biaxially aligned textured structure has been studied. Compared to a metal conductor, the second generation high temperature superconducting wire can transmit much more electric current per unit area of its cross-section. The second generation high temperature superconducting wire may be used in superconducting power transmission and distribution cable with low power loss, a magnetic resonance imaging (MRI), a magnetic levitation train, a superconducting propulsion ship, etc.

### Disclosure of Invention

### Technical Problem

The present disclosure provides superconducting wires including magnetic flux pinning centers.

The present disclosure also provides methods of forming a superconducting wire including magnetic flux pinning centers.

### Solution to Problem

Embodiments of the inventive concept provide methods of forming superconducting wires, the methods including: forming a pinning seed layer on a substrate; depositing a superconducting precursor film on the substrate formed with the pinning seed layer: and heat-treating the substrate deposited with the superconducting precursor film, to form a superconducting film including magnetic flux pinning centers on the substrate, wherein the magnetic flux pinning centers comprise at least one element included in the pinning seed layer, and at least one element included in the superconducting precursor film.

The depositing of the superconducting precursor film may include providing a rare earth element, barium, and copper on the substrate.

The superconducting precursor film may be formed by a reactive co-evaporation process.

The pinning seed layer may comprise zirconium oxide, zirconium, tin oxide, titanium oxide, titanium, hafnium oxide, hafnium, yttrium oxide, cerium oxide or cerium.

The magnetic flux pinning centers may include barium zirconium oxide, barium titanium oxide, barium hafnium oxide or barium cerium oxide.

The substrate may include a metal, or an oxide buffer layer having a textured structure on a metal substrate.

Some embodiments of the inventive concept provide superconducting wires including: a pinning seed layer on a substrate; and a superconducting film directly contacting the pinning seed layer and containing magnetic flux pinning centers arranged vertically on the substrate, wherein the magnetic flux pinning centers comprise at least one element included in the pinning seed layer, and at least one element included in the superconducting film.

The superconducting film may include a rare earth element, barium, and copper.

The magnetic flux pinning centers may include barium metal oxide.

The substrate may include a metal, or an oxide buffer layer having a textured structure on a metal substrate.

### Advantageous Effects of Invention

According to the present invention, magnetic flux pinning centers can be easily formed.

### Brief Description of Drawings

FIGS. 1 through 5 are cross-sectional views illustrating a method of forming a superconducting wire in accordance with embodiments of the present inventive concept;
FIG. 6 is a phase diagram of an yttrium barium copper oxide (YBCO) system;
FIG. 7 is a phase diagram illustrating a method for forming superconducting wire in accordance with an exemplary embodiment of the inventive concept;
FIG. 8 is a phase diagram illustrating a method for forming superconducting wire in accordance with another exemplary embodiment of the inventive concept;
FIG. 9 is a block diagram illustrating an apparatus of forming a superconducting wire in accordance with exemplary embodiments of the inventive concept;
FIG. 10 is a cross-sectional view illustrating a film deposition unit of the apparatus of forming a superconducting wire in accordance with exemplary embodiments of the inventive concept;
FIG. 11 is a plan view illustrating a reel to reel apparatus in accordance with exemplary embodiments of the inventive concept;
FIG. 12 is a cross-sectional view illustrating a heat treatment unit of an apparatus of forming a superconducting wire in accordance with exemplary embodiments of the inventive concept; and
FIG. 13 is graphs illustrating electrical and physical properties of a superconducting wire formed by a method in accordance with exemplary embodiments of the inventive concept.

### Mode for the Invention

Exemplary embodiments of the inventive concept will be described below in more detail with reference to the accompanying drawings. The inventive concept may, however, be embodied in different forms and should not be construed as limited to the embodiments set forth herein. Rather, these embodiments are provided so that this disclosure will be thorough and complete, and will fully convey the scope of the inventive concept to those skilled in the art. Also, since exemplary embodiments are described, reference numerals disclosed according to the sequence of description are not limited to the sequence.

In the following embodiments, YBCO and SmBCO, as examples of superconductors, will be exemplarily described, but the inventive concept is not limited thereto. In the exemplary embodiments of the inventive concept, although the YBCO and the SmBCO have been described as examples of the superconductors, the inventive concept is not limited to the YBCO superconductor and the SmBCO superconductor. The superconductor may comprise Re₁₊ₓBa₂₋ₓCu₃O_{7-y} wherein 0≤x≤0.5, 0≤y≤0.5. The rare earth element (Re) may include yttrium (Y), elements in the lanthanide series, or a combination thereof. The elements in the lanthanide series include lanthanum (La), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), etc.

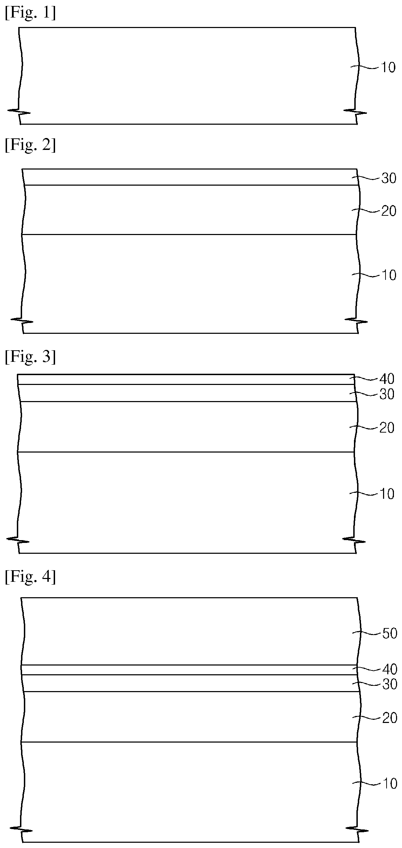

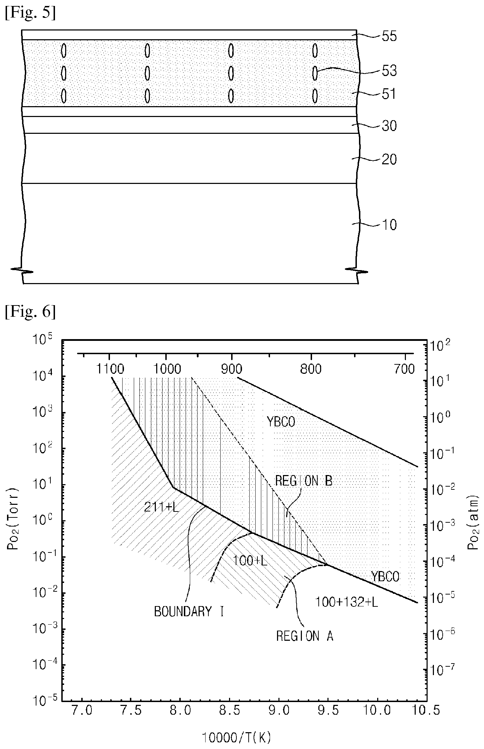

FIGS. 1 through 5 are cross-sectional views illustrating a method of forming a superconducting wire in accordance with embodiments of the present inventive concept. FIG. 6 is a phase diagram of an yttrium barium copper oxide (YBCO) system. A method of forming a superconducting wire in accordance with exemplary embodiments of the inventive concept will be briefly described with reference to FIGS. 1 through 5.

Referring to FIG. 1, a substrate 10 is provided. The substrate 10 may have a biaxially aligned textured structure. The substrate 10 may be a metal substrate. The metal substrate 10 may include a cubic lattice metal, such as nickel (Ni), nickel alloys (Ni-W, Ni-Cr, Ni-Cr-W, etc.), a stainless steel, silver (Ag), silver alloys, nickel-silver composites which are hot rolled. The substrate 10 may have a tape shape for a coated conductor. For example, the substrate 10 may be a metal wire.

Referring to FIG. 2, an IBAD layer 20 may be formed on the substrate 10. The IBAD layer 20 may include a diffusion stop layer (e.g., Al₂O₃), a seed layer (e.g., Y₂O₃), and an MgO layer which are stacked sequentially. The IBAD layer 20 is formed by an IBAD method. An epitaxially grown homoepi-MgO layer may be further formed on the IBAD layer 20. In addition, a buffer layer 30 may be formed on the IBAD layer 20. The buffer layer may include LaMnO₃, LaAlO₃ or SrTiO₃, etc. The buffer layer may be formed by a sputtering method. The IBAD layer 20 and the buffer layer 30 can prevent a reaction between the substrate and the superconductor material on the substrate and transfer crystalline properties of the biaxially aligned textured structure.

Referring to FIG. 3, a pinning seed layer 40 may be formed on the buffer layer 30. The pinning seed layer 40 may include a material able to induce forming of magnetic flux pinning centers in the superconducting film. The pinning seed layer 40 may include, for example, zirconium oxide, zirconium, tin oxide, titanium oxide, titanium, hafnium oxide, hafnium, yttrium oxide, cerium oxide, or cerium. The metal oxides, such as zirconium oxide, tin oxide, titanium oxide, hafnium oxide, yttrium oxide, cerium oxide, and the like may further include barium. The pinning seed layer 40 may be formed by a sputtering method or an electron beam method. The pinning seed layer 40 may have a thickness of about a few ten nanometers.

Referring to FIG. 4, a superconducting precursor film 50 may be formed on the pinning seed layer 40. It may be understood that the superconducting precursor film 50 is in an amorphous state that has not been subject to crystallization. The superconducting precursor film 50 may include at least one of rare earth (RE) elements, copper (Cu), and barium (Ba).

The superconducting precursor film 50 may be formed by various methods. For example, the superconducting precursor film 50 may be formed by a reactive co-evaporation method, a laser ablation method, a chemical vapor deposition (CVD) method, a metal organic deposition (MOD) method, or a sol-gel method.

In an exemplary embodiment, the superconducting precursor film 50 may be formed by the reactive co-evaporation method. For depositing the superconducting precursor film, the reactive co-evaporation method may include providing metal vapor which is generated by irradiating electron beam onto crucibles containing at least one of rare earth elements, copper (Cu) and barium (Ba). The rare earth elements may include yttrium (Y), elements in the lanthanide series, or a combination thereof. The elements in the lanthanide series include lanthanum (La), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), etc.

In another exemplary embodiment, the superconducting precursor film 50 may be formed by the MOD method. For example, a metal precursor solution is prepared by dissolving rare earth element-acetate, barium-acetate and copper-acetate in a solvent, evaporating and distilling the dissolved solution, and refluxing the distilled vapor. The metal precursor solution may be coated on the substrate.

Referring to FIG. 5, the substrate 10 on which the superconducting precursor film 50 is formed is heat-treated, so that a superconducting film 51 epitaxially grows on the substrate 10. By the heat treatment, a material included in the pinning seed layer 40 may move to the superconducting precursor film 50. The material included in the pinning seed layer 40 may rapidly react with a material included in the superconducting precursor film 50 to generate nanoscale defects 53. The defects 53 generated in the epitaxially grown superconducting film 51 may function as magnetic flux pinning centers for the superconductor. The defects 53 may be arranged vertically in agglomerates separated from each other on the substrate 10. The defects 53 may include at least one element included in the pinning seed layer 40, and at least one element (e.g., Ba) included in the superconducting precursor film 50. The defects 53 may include barium metal oxide, such as barium zirconium oxide, barium titanium oxide, barium hafnium oxide, or barium cerium oxide. While the drawing illustrates that the pinning seed layer 40 remains even after the heat treatment, the present invention is not limited thereto. That is, all the material included in the pinning seed layer 40 may move to the defects 53, so that the pinning seed layer 40 may not remain.

Referring to FIG. 6, a heat treatment of the superconducting precursor film 50 will be described in more detail. REBCO, which is the superconducting precursor film 50 described with reference to FIGS. 1 through 4, may be understood to be RE₂BaCuO₅ (hereinafter, referred to as '211'), RE₂O₃ (hereinafter, referred to as '100'), REBa₃Cu₂O₆ (hereinafter, referred to as '132'), and liquid (hereinafter, referred to as 'L'). The 'L' indicates a liquid including Ba, Cu and O as main components, into which RE may be melted. In a gray region, REBCO which is thermodynamically stable appears.

The substrate 10 on which the superconducting precursor film 50 is formed is heat-treated. An oxygen partial pressure and/or a heat treatment temperature may be controlled such that among the decomposition components of the REBCO, the liquid state 'L' including Ba, Cu and O as main components, into which RE can partially melted is made. At this time, the REBCO may be formed while the REBCO system passes through a coexistence region of 'L' and '100'(refer to a region A illustrated in FIG. 6). By controlling the oxygen partial pressure and/or the heat treatment temperature, while the REBCO system passes through a boundary I, a stable epitaxial superconducting film may be formed through a reaction of '100' from 'L' in the liquid state. More particularly, nuclei are formed from the '100' coexisting in the 'L' on the substrate 10 so that the superconducting film 51 epitaxially grows (refer to a region B shown in FIG. 6).

Again referring to FIG. 5, a residual film 55 having a different phase from the superconducting film 51 may be further formed on the REBCO superconducting film 51. In the REBCO superconducting film 51, a ratio of a rare earth element, barium and copper is about 1: 2: 3, and in the residual film 55, a ratio of a rare earth element, barium and copper may be different from that in the REBCO superconducting film 51. This is because while the REBCO superconducting film 51 epitaxially grows from the 'L' and '100', the superconducting precursor remains on the REBCO superconducting film 51. Therefore, the residual layer 55 including a nonstoichiometric oxide which is a trace of the superconducting precursor may be formed on the REBCO superconducting film 51 formed finally. The residual film 55 may include at least one phase which has a crystal structure different from that of the REBCO superconducting film 51. The REBCO superconducting film 51 may further include grains of '100'.

In the method of forming the REBCO superconducting film 51 as described above, the superconducting precursor film 50 may be formed such that a ratio of a rare earth element, barium and copper is about 1: x: 3 (0<x<2). For example, the superconducting precursor film may be formed such that the ratio of a rare earth element, barium and copper is about 1: 1.5: 3. Since the REBCO precursor of which a ratio of a rare earth element, barium and copper is about 1: 2: 3 generally decomposes in the air, the REBCO precursor including the ratio of about 1: 2: 3 is unstable. In contrast to the REBCO precursor including the ratio of about 1: 2: 3, the REBCO precursor of which a ratio of the rare earth element, barium and copper is about 1: 1.5: 3 is stable in the air. Therefore, although the REBCO precursor film having the ratio of about 1: 2: 3 should be under a vacuum before the heat treatment process of the REBCO precursor film, the REBCO precursor film having the ratio of about 1: 1.5: 3 may be exposed to the air before the heat treatment process of the REBCO precursor film. The REBCO precursor film having the ratio of about 1: x: 3 (1<x<2) may become a REBCO superconducting film 51 of which the ratio of the rare earth element, barium and copper is about 1: 2: 3 and the residual film 55 of which the ratio of the rare earth element, barium and copper is different from that in the REBCO superconducting film 51 by the heat treatment process as described above. In this case, the residual film 55 may include BaCu₂O₂ (hereinafter, referred to as '012') in a solid state. The '100' is consumed during the epitaxial growth of the REBCO superconducting film 51.

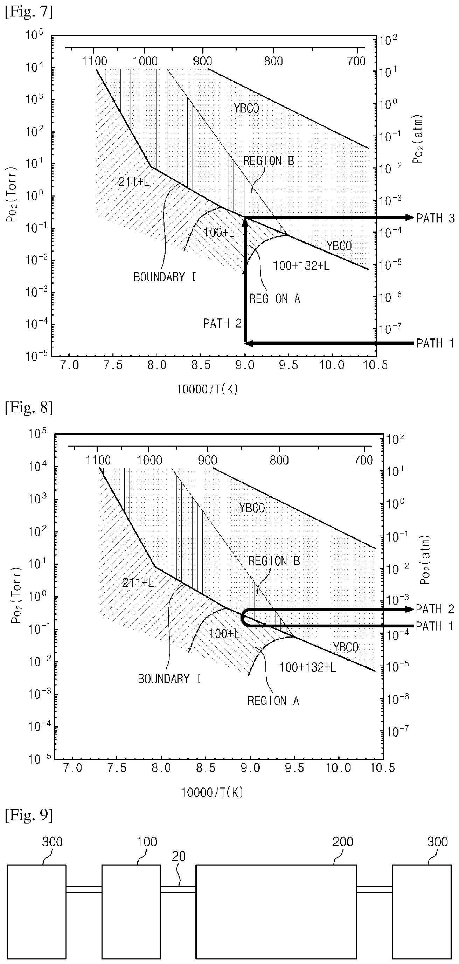

A method of the superconducting wire in accordance with exemplary embodiments of the inventive concept will be described in detail with reference to examples of various heat treatment paths in the YBCO phase diagram of FIG. 6. FIGS. 7 and 8 are phase diagrams illustrating a method for forming superconducting wire in accordance with exemplary embodiments of the inventive concept.

Methods of forming superconducting wires in accordance with exemplary embodiments of the inventive concept will be described with reference to FIG. 7.

As described above, a superconducting precursor film is formed on the substrate. The superconducting precursor film, REBCO may be understood to be decomposed into '100' and 'L'. 'L' is in the solid state at a low temperature, and a main component of the solid is '012'. That is, during a process of decomposing the REBCO, a solid '012' appears.

The substrate on which the superconducting precursor film is deposited is heat-treated. The heat treatment process may be performed according to a path of the phase diagram shown in FIG. 7. The heat treatment process according to a path 1 may be performed under a relatively low oxygen partial pressure (e.g., about 1×10⁻⁵ Torr to 1×10⁻⁴Torr). A temperature of the heat treatment process may increase from room temperature to about 800°C.

An oxygen partial pressure and/or a heat treatment temperature are controlled according to a path 2 of the phase diagram shown in FIG. 7 such that the '012' of the decomposition components of the REBCO is in the liquid state. For example, the oxygen partial pressure may be increased to about 1×10⁻² Torr to about 3×10⁻¹ Torr (1 Torr = 133.32 Pa). The temperature of the heat treatment process may be, for example, higher than 800 °C. At this time, the REBCO may be understood to include coexistence of 'L' and '100'.

Since the oxygen partial pressure and/or the heat treatment temperature are controlled along a path 3 of the phase diagram shown in FIG. 7, which crosses the boundary I, a stable epitaxial REBCO film may be formed from 'L'. For example, the oxygen partial pressure may be in a range of about 5×10⁻² Torr to about 3×10⁻¹ Torr. The heat treatment temperature may be decreased to about 800°C or less, for example, to room temperature. More particularly, nuclei are generated from the 'L' and '100' coexisting in the liquid state on the substrate so that the REBCO superconducting film epitaxially grows.

FIG. 8 is a phase diagram illustrating a method for forming superconducting wire in accordance with another exemplary embodiment of the inventive concept.

Methods of forming superconducting wires in accordance with exemplary embodiments of the inventive concept will be described with reference to FIG. 8. Any repetitive explanation concerning technical features and functions which are the same as those of the above-described exemplary embodiments will be omitted.

In the same manner as the exemplary embodiments described above, a superconducting precursor film is formed on a substrate. The substrate on which the superconducting precursor film is formed is heat-treated. The heat treatment process may be performed according to a path of the phase diagram illustrated in FIG. 8. For example, the heat treatment process according to a path 1 may be performed under an oxygen partial pressure of about 5×10⁻² Torr to about 3×10⁻¹ Torr. The heat treatment temperature may be increased from room temperature to about 800°C or higher. The oxygen partial pressure and/or the heat treatment temperature are controlled according to the path 1 so that the '012' may be in a liquid state. At this time, the REBCO may be understood to include the coexistence of 'L' and '100' in the liquid state.

Since the oxygen partial pressure and/or the heat treatment temperature are controlled according to a path 2 of the phase diagram shown in FIG. 8, which crosses the boundary I, a stable REBCO superconducting film may be formed. For example, the oxygen partial pressure may be in a range of about 5×10⁻² Torr to about 3×10⁻¹ Torr. The heat treatment temperature may be decreased to about 800 °C or less, for example, to room temperature. More particularly, nuclei are generated from the '100' coexisting with 'L' in the liquid state on the substrate so that the REBCO superconducting film epitaxially grows.

Growth processes of the REBCO superconducting fim in accordance with exemplary embodiments described above is similar to a liquid phase epitaxy (LPE). Since FIGS. 6, 7 and 8 are phase diagrams of an YBCO system, the oxygen partial pressure and the heat treatment temperature may vary according to the rare earth elements.

A system of forming a superconducting wire in accordance with an exemplary embodiment of the inventive concept will be described with reference to FIGS. 6 to 9. The system of forming the superconducting wire described with reference to FIGS. 6 to 9 is one exemplary embodiment of the inventive concept and the inventive concept is not limited to the system of forming the superconducting wire described with reference to FIGS. 6 to 9.

FIG. 9 is a block diagram illustrating an apparatus of forming a superconducting wire in accordance with exemplary embodiments of the inventive concept. Referring to FIG. 9, an apparatus of forming a superconducting wire includes a film deposition unit 100, a heat treatment unit 200 and a wire supply/collection unit 300. The film deposition unit 100 forms a superconducting precursor film on a substrate. The heat treatment unit 200 thermally treats the substrate on which the superconducting precursor film is formed. A vacuum pipe 20 may be further provided between the film deposition unit 100, the heat treatment unit 200 and the wire supply/collection unit 300. The vacuum pipe 20 maintains a vacuum state and the wire substrate 10 passes through the vacuum pipe 20.

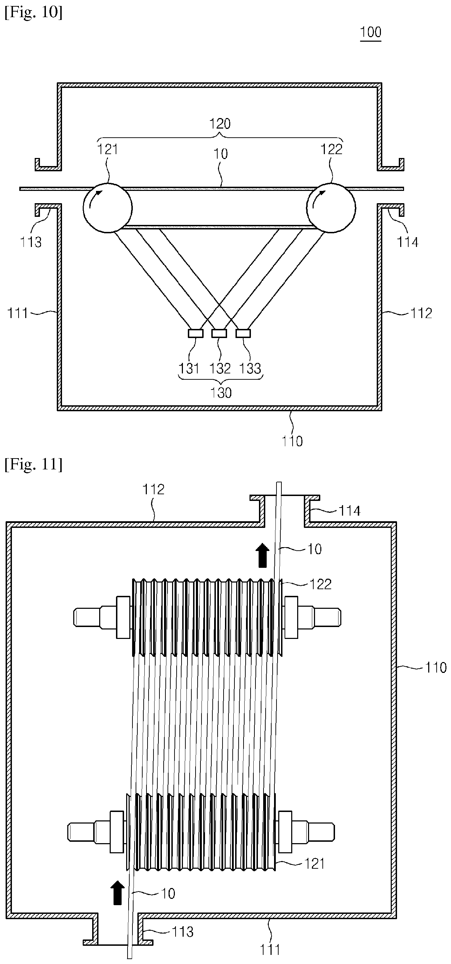

FIG. 10 is a cross-sectional view illustrating the film deposition unit 100 of the apparatus of forming a superconducting wire in accordance with exemplary embodiments of the inventive concept. Referring to FIGS. 9 and 10, the film deposition unit 100 includes a process chamber 110, a reel to reel apparatus 120, and a deposition member 130. For example, the process chamber 110 provides a space in which a deposition process for forming the superconducting precursor film on the substrate 10 is performed. The process chamber 110 includes a first sidewall 111 and a second sidewall 112 which face each other. The first sidewall 111 is provided with an incoming part 113 which is connected to the wire supply/collection unit 300. The second sidewall 112 is provided with an outgoing part 114 which is connected to the heat treatment unit 200. The substrate 10 is transported from the wire supply/collection unit 300 to enter the process chamber 110 through the incoming part 113. Then, the substrate 10 gets out from the process chamber 110 through the outgoing part 114 to enter the heat treatment unit 200.

The deposition member 130 may be provided under the reel to reel device 120. The deposition member 130 provides vapor of the superconductor material to a surface of the substrate 10. In an exemplary embodiment, the deposition member 130 may provide the superconducting precursor film on the substrate 10, using the co-evaporation method. The deposition member 130 may include metal vapor sources 131, 132 and 133 which provide metal vapor under the substrate 10 using electron beam. The metal vapor sources may include sources for the rare earth element, barium and copper.

FIG. 11 is a plan view of a reel to reel apparatus in accordance with exemplary embodiments of the inventive concept. Referring to FIGS. 9 and 10, the reel to reel apparatus includes a first reel member 121 and a second reel member 122. The first and second reel members 121 and 122 facing each other are separated from each other. The deposition member 130 is disposed under the substrate which is disposed between the first and second reel members 121 and 122. The first and second reel members 121 and 122 multi-turn the substrate 10 at a region in which the superconducting precursor film is deposited. For example, the substrate 10 travels between the first and second reel member 121 and 122 and is turned by the first and second reel members 121 and 122. The first reel member 121 is adjacent to the first sidewall 111 of the process chamber 110 and the second reel member 122 is adjacent to the second sidewall 112 of the process chamber 110. A structure of the first reel member 121 may be substantially the same as that of the second reel member 122. The first and second reel members 121 and 122 may extend in a direction which crosses the traveling direction of the substrate 10.

Each of the first and second reel members 121 and 122 may include reels disposed along the extension direction of the first and second reel members 121 and 122 and combined with each other. The substrate 10 is turned by each of the reels. Each of the reels may be independently driven and is rolled by friction with the substrate 10. When viewed in a plan, the second reel member 122 may be slightly offset with the first reel member 121 so that the substrate 10 is multi-turned by the first and second reel members 121 and 122. The substrate 10 travels between the first and second reel members 121 and 122 along the extension direction of the first and second reel members 121 and 122.

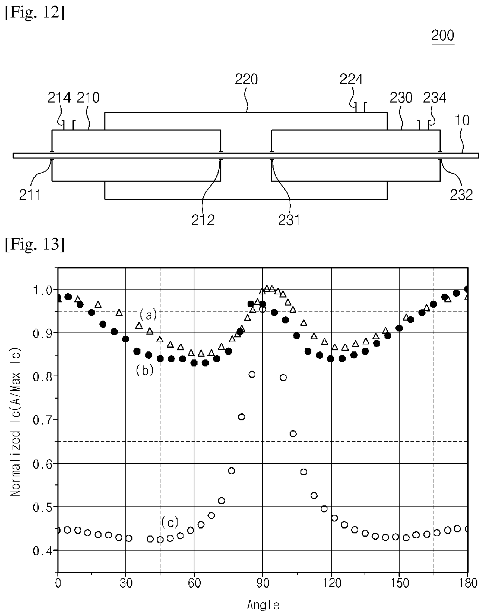

FIG. 12 is a cross-sectional view illustrating the heat treatment unit 300 of the apparatus of forming the superconducting wire in accordance with exemplary embodiments of the inventive concept. Referring to FIG. 12, the heat treatment unit 200 may include a first container 210, a second container 220 and a third container 230 which are adjacent to each other, sequentially. The substrate 10 can successively pass the first container 210, the second container 220 and the third container 230. The first container 210 and the third container 230 are separated from each other. A center portion of the second container 220 may be disposed to correspond to the separation region of the first and third containers 210 and 230. The second container 220 may surround a portion of the first container 210 and a portion of the third container 230. The first container 210, the second container 220 and the third container 230 may include a substantially cylindrical tube which is formed using quartz. The first container 210 may be connected to the outgoing part 114 of the film deposition unit 100. The first container 210 may include a first incoming part 211 and a first outgoing part 212 for passing the substrate 10, which are respectively formed at both ends of the first container 210, and the third container 230 may include a second incoming part 231 and a second outgoing part 232 for passing the substrate 10, which are respectively formed at both ends of the third container 210. The substrate 10 enters the first container 210 through the first incoming part 211 of the first container 210 and gets out of the first container 210 through the first outgoing part 212 of the first container 210. Then, after the substrate 10 passes through the center portion of the second container 220, the substrate 100 enters the third container 230 through the second incoming part 231 and gets out of the third container 230 through the second outgoing part 232.

The first, second and third containers 210, 220 and 230 may respectively include pumping ports 214, 224 and 234. Therefore, the first, second and third containers 210, 220 and 230 may independently maintain a vacuum state. Since oxygen is provided through the oxygen supply lines 215, 225 and 235, the oxygen partial pressure of the first container 210, the oxygen partial pressure of the second container 220 and the oxygen partial pressure of the third container 230 may be controlled independently. For example, the oxygen partial pressure of the first container 210 may be lower than the oxygen partial pressure of the third container 230, and the oxygen partial pressure of the second container 220 may be between the oxygen partial pressure of the first container 210 and the oxygen partial pressure of the third container 230. In the second container 220, as going from a first portion adjacent to the first container 210 to a second portion adjacent to the third container 230, the oxygen partial pressure may increase.

The first container 210, the second container 220 and the third container 230 may be provided in a furnace surrounding the first container 210, the second container 220 and the third container 230. The separation region of the first container 210 and the third container 230 may be positioned to correspond to a center portion of the furnace. Accordingly, a temperature at the center portion of the second container 220 may be higher than temperatures in the first and third containers 210 and 230. The temperature in the first container 210 and the temperature of the third container 230 may decrease as it goes far from the center portion of the second container 220.

The heat treatment process described with reference to FIG. 7 will be described with the heat treatment unit 200 illustrated in FIG. 12. While the substrate 10 passes through the first container 210 of the heat treatment unit 200, the treatment process along the path 1 may be performed. The first container 210 may have a relatively low oxygen partial pressure. For example, the oxygen partial pressure of the first container 210 may be in a range of about 1×10⁻⁵ Torr to about 1×10⁻⁴ Torr. As going from the first incoming part 211 to the first outgoing part 212, the temperature in the first container 210 may increase. For example, at the first outgoing part 212, the temperature in the first container 210 may be about 800?. While the substrate 10 passes through the second container 220 of the heat treatment unit 200, the treatment process along the path 2 may be performed.. For example, the oxygen partial pressure of the second container 220 may be in a range of about 1×10⁻² Torr to about 1×0⁻¹ Torr. In the second container 220, as going from a first portion adjacent to the first container 210 to a second portion adjacent to the third container 230, the oxygen partial pressure may increase. The temperature at the center portion of the second container 220 may be the same as or higher than about 800°C. While the substrate 10 passes through the second portion of the second container 220 and the third container 230 of the heat treatment unit 200, the treatment process along the path 3 may be performed. For example, the oxygen partial pressure of the third container 230 may be in a range of about 5×10⁻² Torr to about 3×10⁻¹ Torr. In the third container 230, as going from the second incoming part 231 to the second outgoing part 232, the temperature may decrease. For example, in the third container 230, the temperature at the second incoming part 221 may be about 800°C.

The heat treatment process described with reference to FIG. 8 will be described with the heat treatment unit 200 illustrated in FIG. 12. The first, second and third containers 210, 220 and 230 are constructed to maintain the vacuum state not independently but dependently. In an exemplary embodiment, the first, second and third containers 210, 220 and 230 may maintain the vacuum state using a single pumping port. In another exemplary embodiment, the first, second and third containers 210, 220 and 230 may be constructed as a single cylindrical container.

While the substrate 10 travels from the incoming part of the heat treatment unit 200 to the center portion of the heat treatment unit 200 of the heat treatment unit 200, the treatment process along the path 1 may be performed. While the substrate 10 travels from the center portion of the heat treatment unit 200 to the outgoing part of the heat treatment unit 200, the treatment process along the path 2 may be performed. For example, the oxygen partial pressure of the heat treatment unit 200 may be in a range of about 1×10⁻² Torr to about 3×10⁻¹ Torr. The temperature at the center portion of the heat treatment unit 200 may be the same as or higher than about 800 °C. In the heat treatment unit 200, as going from the center portion to the incoming part and from the center portion to the outgoing part, the temperature may decrease.

In the exemplary embodiment described above, although the film deposition unit 100, the heat treatment unit 200 and the wire supply/collection unit 300 are constructed as a single so that the substrate is successively transported, the inventive concept is not limited to the exemplary embodiment. For example, the wire supply/collection unit may be provided to each of the film deposition unit 100 and the heat treatment unit 200. A reel wound by the substrate 10 is provided to the wire supply/collection unit of the film deposition unit 100. The film deposition unit 100 forms the superconducting precursor film on the substrate 10. The film deposition unit 100 may have a structure which is different from that of the exemplary embodiment described above. For example, the film deposition unit 100 may be for metal organic deposition (MOD). The reel wound by the substrate on which the superconducting precursor film is formed is separated from the film deposition unit 100. The substrate 10 on which the superconducting precursor film is formed may be provided to the heat treatment unit 200. Then, the substrate on which the superconducting precursor film is formed is heated.

FIG. 13 illustrates critical current properties under an external magnetic field, of superconducting wires formed by methods in accordance with exemplary embodiments of the inventive concept, and a superconducting wire formed by a general method. Particularly, (a) of FIG. 13 corresponds to a case where a pinning seed layer includes hafnium, (b) corresponds to a case where a pinning seed layer includes zirconium, and (c) corresponds to a case of a superconducting wire formed by a general method. A superconducting material in this measurement was SmBCO, the temperature of the superconducting wire was 77K, and the magnetic field was 6,300 Gauss. The magnetic field was maintained at the constant value, and the critical current was measured while the direction of the magnetic field was changed. In the drawing, the angel '0' indicates that the direction of the magnetic field is parallel to the surface of the superconducting wire, and the angel '90' indicates that the direction of the magnetic field is vertical to the surface of the superconducting wire. The critical current of the superconducting wires according to the inventive concept was varied within 20% according to the angles, whereas the critical current of the superconducting wire formed by the general method was varied above 50%. When a current above the critical current flows through the superconducting wire, it loses the superconductivity thereof. In power devices such as a motor, a generator, etc., a magnetic field is generated by a current flowing therethrough, and it is difficult to control the direction of the generated magnetic field. Therefore, the critical current of the superconducting wire is determined by the smallest value according to the angles. Since the superconducting wires according to the inventive concept have a little variation in critical current, they may be advantageously applied to power devices.

According to the present invention, magnetic flux pinning centers can be easily formed.

The above-disclosed subject matter is to be considered illustrative and not restrictive, and the appended claims are intended to cover all such modifications, enhancements, and other embodiments, which fall within the true spirit and scope of the inventive concept. Thus, to the maximum extent allowed by law, the scope of the inventive concept is to be determined by the broadest permissible interpretation of the following claims and their equivalents, and shall not be restricted or limited by the foregoing detailed description.

## Claims

1. A method of forming a superconducting wire, the method comprising:
forming a pinning seed layer on a substrate, wherein the pinning seed layer comprises hafnium;
depositing a superconducting precursor film on the substrate formed with the pinning seed layer; and
heat-treating the substrate deposited with the superconducting precursor film, such that a superconducting film including magnetic flux pinning centers is formed,
wherein the magnetic flux pinning centers comprise hafnium that moves from the pinning seed layer during the heat-treating, and at least one element included in the superconducting precursor film.

2. The method of claim 1, wherein the depositing of the superconducting precursor film comprises providing a rare earth element, barium, and copper on the substrate.

3. The method of claim 2, wherein the superconducting precursor film is formed by a reactive co-evaporation process.

4. The method of claim 1, wherein the pinning seed layer comprises hafnium or hafnium oxide.

5. The method of claim 4, wherein the magnetic flux pinning centers comprise barium hafnium oxide.

6. The method of claim 1, wherein the substrate comprises a metal, or an oxide buffer layer having a textured structure on a metal substrate.

7. A superconducting wire comprising:
a substrate;
a pinning seed layer on the substrate, wherein the pinning seed layer comprises hafnium; and
a superconducting film directly contacting the pinning seed layer and containing magnetic flux pinning centers arranged vertically on the substrate,
wherein the magnetic flux pinning centers comprise hafnium included in the pinning seed layer, and at least one element included in the superconducting film.

8. The superconducting wire of claim 7, wherein the superconducting film comprises a rare earth element, barium, and copper.

9. The superconducting wire of claim 8, wherein the magnetic flux pinning centers comprise barium hafnium oxide.

10. The superconducting wire of claim 7, wherein the substrate comprises a metal, or an oxide buffer layer having a textured structure on a metal substrate.

11. The method of claim 1, wherein the heat-treating the substrate comprises:
increasing a temperature of the substrate to a first temperature higher than room temperature at a first pressure, such that the pinning seed layer and the superconducting precursor is in a liquid state;
increasing an oxygen partial pressure of a processing chamber in which the substrate is provided, such that the magnetic flux pinning centers form in the superconducting precursor; and
decreasing the temperature of the substrate to form an epitaxy ceramic film from the liquid superconducting precursor on the substrate.

12. The method of claim 11, wherein the oxygen partial pressure of the processing chamber is increased from 0.013332 Pa to 1.3332 Pa or alternatively, 1×10⁻⁴ Torr to 1×10⁻² Torr.

## Patentansprüche

1. Verfahren zum Ausbilden eines supraleitenden Drahtes, wobei das Verfahren umfasst:
Ausbilden einer Haftsaatschicht auf einem Substrat, worin die Haftsaatschicht Hafnium umfasst;
Abscheiden einer Supraleitervorläufer-Dünnschicht auf dem mit der Haftsaatschicht ausgebildeten Substrat; und
Wärmebehandeln des mit der Supraleitervorläufer-Dünnschicht beschichteten Substrats, sodass eine supraleitende Dünnschicht ausgebildet wird, die Haftzentren für den magnetischen Fluss aufweist,
worin die Haftzentren für den magnetischen Fluss Hafnium, das sich während der Wärmebehandlung von der Haftsaatschicht fortbewegt, und mindestens ein in die Supraleitervorläufer-Dünnschicht eingeschlossenes Element umfassen.

2. Verfahren nach Anspruch 1, worin das Abscheiden der Supraleitervorläufer-Dünnschicht umfasst: Bereitstellen von einem Seltenerdelement, Barium und Kupfer auf dem Substrat.

3. Verfahren nach Anspruch 2, worin die Supraleitervorläufer-Dünnschicht durch einen reaktiven Co-Verdampfungsprozess ausgebildet wird.

4. Verfahren nach Anspruch 1, worin die Haftsaatschicht Hafnium oder Hafniumoxid umfasst.

5. Verfahren nach Anspruch 4, worin die Haftzentren für den magnetischen Fluss Bariumhafniumoxid umfassen.

6. Verfahren nach Anspruch 1, worin das Substrat ein Metall oder eine Oxidpufferschicht mit einer texturierten Struktur auf einem Metallsubstrat umfasst.

7. Supraleitender Draht, umfassend:
ein Substrat;
eine Haftsaatschicht auf dem Substrat, worin die Haftsaatschicht Hafnium umfasst; und
eine supraleitende Dünnschicht, welche die Haftsaatschicht direkt berührt und Haftzentren für den magnetischen Fluss enthält, die vertikal auf dem Substrat angeordnet sind,
worin die Haftzentren für den magnetischen Fluss in die Haftsaatschicht eingeschlossenes Hafnium und mindestens ein in die supraleitende Dünnschicht eingeschlossenes Element umfassen.

8. Supraleitender Draht nach Anspruch 7, worin die supraleitende Dünnschicht ein Seltenerdelement, Barium und Kupfer umfasst.

9. Supraleitender Draht nach Anspruch 8, worin die Haftzentren für den magnetischen Fluss Bariumhafniumoxid umfassen.

10. Supraleitender Draht nach Anspruch 7, worin das Substrat ein Metall oder eine Oxidpufferschicht mit einer texturierten Struktur auf einem Metallsubstrat umfasst.

11. Verfahren nach Anspruch 1, worin das Wärmebehandeln des Substrats umfasst:
Erhöhen einer Temperatur des Substrats bei einem ersten Druck auf eine erste Temperatur, die höher als Zimmertemperatur ist, sodass die Haftsaatschicht und der Supraleitervorläufer in einem flüssigen Zustand sind;
Erhöhen eines Sauerstoff-Partialdrucks einer Prozesskammer, in der das Substrat bereitgestellt ist, sodass sich im Supraleitervorläufer die Haftzentren für den magnetischen Fluss ausbilden; und
Verringern der Temperatur des Substrats, um eine keramische Epitaxie-Dünnschicht aus dem flüssigen Supraleitervorläufer auf dem Substrat auszubilden.

12. Verfahren nach Anspruch 11, worin der Sauerstoff-Partialdruck der Prozesskammer von 0,013332 Pa auf 1,3332 Pa oder alternativ von 1×10⁻⁴ Torr auf 1×10⁻² Torr erhöht wird.

## Revendications

1. Procédé de formation d'un câble supraconducteur, le procédé comprenant :
la formation d'une couche germe d'ancrage sur un substrat, dans lequel la couche germe d'ancrage comprend de l'hafnium ;
le dépôt d'un film de précurseur supraconducteur sur le substrat formé avec la couche germe d'ancrage ; et
le traitement thermique du substrat déposé avec le film de précurseur supraconducteur, de telle sorte qu'un film supraconducteur comportant des centres d'ancrage de flux magnétique est formé,
dans lequel les centres d'ancrage de flux magnétique comprennent de l'hafnium qui se déplace à partir de la couche germe d'ancrage pendant le traitement thermique, et au moins un élément inclus dans le film de précurseur supraconducteur.

2. Procédé selon la revendication 1, dans lequel le dépôt du film de précurseur supraconducteur comprend la fourniture d'un élément des terres rares, du baryum, et du cuivre sur le substrat.

3. Procédé selon la revendication 2, dans lequel le film de précurseur supraconducteur est formé par un processus de coévaporation réactive.

4. Procédé selon la revendication 1, dans lequel la couche germe d'ancrage comprend de l'hafnium ou un oxyde d'hafnium.

5. Procédé selon la revendication 4, dans lequel les centres d'ancrage de flux magnétique comprennent un oxyde de baryum et d'hafnium.

6. Procédé selon la revendication 1, dans lequel le substrat comprend un métal, ou une couche tampon d'oxyde ayant une structure texturée sur un substrat en métal.

7. Câble supraconducteur comprenant :
un substrat ;
une couche germe d'ancrage sur le substrat, dans lequel la couche germe d'ancrage comprend de l'hafnium ; et
un film supraconducteur entrant directement en contact avec la couche germe d'ancrage et contenant des centres d'ancrage de flux magnétique agencés dans le sens vertical sur le substrat,
dans lequel les centres d'ancrage de flux magnétique comprennent de l'hafnium inclus dans la couche germe d'ancrage, et au moins un élément inclus dans le film supraconducteur.

8. Câble supraconducteur selon la revendication 7, dans lequel le film supraconducteur comprend un élément des terres rares, du baryum, et du cuivre.

9. Câble supraconducteur selon la revendication 8, dans lequel les centres d'ancrage de flux magnétique comprennent un oxyde de baryum et d'hafnium.

10. Câble supraconducteur selon la revendication 7, dans lequel le substrat comprend un métal, ou une couche tampon d'oxyde ayant une structure texturée sur un substrat en métal.

11. Procédé selon la revendication 1, dans lequel le traitement thermique du substrat comprend :
l'accroissement d'une température du substrat à une première température supérieure à la température ambiante à une première pression, de telle sorte que la couche germe d'ancrage et le précurseur supraconducteur sont dans un état liquide ;
l'accroissement d'une pression partielle d'oxygène d'un compartiment de traitement dans lequel le substrat est prévu, de telle sorte que les centres d'ancrage de flux magnétique se forment dans le précurseur supraconducteur ; et
la diminution de la température du substrat pour former un film céramique épitaxial à partir du précurseur supraconducteur liquide sur le substrat.

12. Procédé selon la revendication 11, dans lequel la pression partielle d'oxygène du compartiment de traitement est accrue de 0,013332 Pa à 1,3332 Pa ou en variante de 1 x 10⁻⁴ Torr à 1 x 10⁻² Torr.
